# EUROPÄISCHE PATENTANMELDUNG

(11) **EP 0 707 249 A2**
(43) Veröffentlichungstag der Anmeldung: **17.04.1996**
(21) Anmeldenummer: 95115410.3
(22) Anmeldetag: 29.09.1995
(51) Int. Cl.: G05B 19/042

(54) **Einrichtung zur Steuerung von mechanischen oder elektromechanischen Stellgliedern**

(30) Priorität: 12.10.1994 DE 4436405
(71) Anmelder: ROBERT BOSCH GMBH, D-70442 Stuttgart (DE)
(72) Erfinder: Giere, Dirk, Dipl.-Ing., D-71679 Asperg (DE)

(57) **Zusammenfassung**

Es wird eine Einrichtung zur Steuerung von mechanischen oder elektromechanischen Stellgliedern, insbesondere mit pneumatischen Bauelementen, vorgeschlagen, bei der die Stellglieder (1,2,3) über mindestens eine Verteileranordnung (9,10) betätigt werden und die Verteileranordnung (9,10) über ein elektronisches Bussystem (12) mit einer speicherprogrammierbaren, zentralen Steuereinheit (13) verbunden ist. Um einen einfachen und platzsparenden Aufbau der Einrichtung zu gewährleisten, sind Signalleitungen (5) zur Zustandsüberwachung der Sensoren oder Detektoren (4) an den Stellgliedern (1,2,3) mit Buskoppelbausteinen (6) verbunden, die an einem zweiten elektronischen Bussystem (8) angeschlossen sind. Das zweite elektronische Bussystem (8) ist hierbei an die Verteileranordnung (9,10) und an die Steuereinheit (13) angeschlossen.

## Beschreibung

### Stand der Technik

Die Erfindung betrifft eine Einrichtung zur Steuerung von mechanischen oder elektromechanischen Stellgliedern, insbesondere von pneumatischen Bauelementen, die über eine Verteileranordnung versorgt werden, nach der Gattung des Hauptanspruchs.

Es ist bereits aus der DE-PS 30 42 205 eine Einrichtung bekannt, bei der pneumatische Stellglieder als Bestandteil einer Maschinensteuerung vorhanden sind. Diese Stellglieder werden über eine sogenannte Verteilerinsel gesteuert, wobei diese Verteilerinsel eine Anzahl Schalt- und/oder Steuermodule zur Weiterleitung eines Schalt- oder Steuerdrucks an die Stellglieder aufweist. Zur Realisierung einer wirkungsvollen Maschinensteuerung erfolgt eine elektrische Ansteuerung der Schalt- und Steuermodule über eine zentrale Verbindungsleitung. Diese zentrale Verbindungsleitung verbindet eventuell auch eine Vielzahl solcher Verteilerinseln mit einer zentralen Steuereinheit, wobei die Verbindungsleitung zur Übertragung vieler Signale in beiden Richtungen als elektronisches Bussystem aufgebaut ist.

Bei der Steuerung einer Maschine über die Stellglieder ist es hierbei notwendig auch die Schaltstellungen der Stellglieder zu erfassen und zur zentralen Steuereinheit zu übertragen. Beim Stand der Technik erfolgt diese Rückmeldung über separate Leitungen, die von den einzelnen Stellgliedern jeweils einzeln zunächst zu den Verteilerinseln geführt sind und von dort in die zentrale Verbindungsleitung eingeschleust werden. Diese bekannte Art des Aufbaus der Verbindungsleitungen kann bei einer Vielzahl von Stellgliedern und Verteilerinseln zu einem erheblichen Verkabelungsaufwand führen, der insbesondere bei einem engen Aufbau, beispielsweise im Motorraum eines Kraftfahrzeugs, hinderlich ist.

### Vorteile der Erfindung

Die erfindungsgemäße Einrichtung zur Steuerung von mechanischen oder elektromechanischen Stellgliedern mit den kennzeichnenden Merkmalen des Anspruchs 1 ist dadurch vorteilhaft, daß der Verkabelungsaufwand durch das erfindungsgemäße zweite Bussystem erheblich verringert werden kann. Die zusätzlich Anordnung von Buskoppelbausteinen an den Stellgliedern stellt hierbei nur einen geringfügigen Mehraufwand dar, der schon deshalb kaum ins Gewicht fällt, da elektronische Komponenten in den allermeisten Fällen bereits in die Stellglieder integriert sind oder einfach integriert werden können. Eine direkte räumliche Zuordnung der Sensoren beziehungsweise Detektoren zur Erfassung der Schaltzustände der Stellglieder zu den Buskoppelbausteinen ist ohne weiteres möglich. Auch sind die erforderlichen Bausteine in der Regel weitgehend standardisiert, so daß die zusätzlichen Kosten geringer sind als die Einsparung bei der Verkabelung.

Weiterhin ist eine einfachere Signalverarbeitung zwischen den Stellgliedern und den Verteileranordnungen sowie der zentralen Steuereinheit durchführbar, da auch das zweite Bussystem ein standardisiertes Übertragungsverfahren aufweist, das beispielsweise auch die Servicemöglichkeiten verbessert.

Vorteilhafte Ausführungsformen der erfindungsgemäßen Einrichtung sind in den Unteransprüchen angegeben, die insbesondere einen einfachen Aufbau der Bussysteme und der im wesentlichen pneumatischen Maschinensteuerung gewährleisten.

### Zeichnung

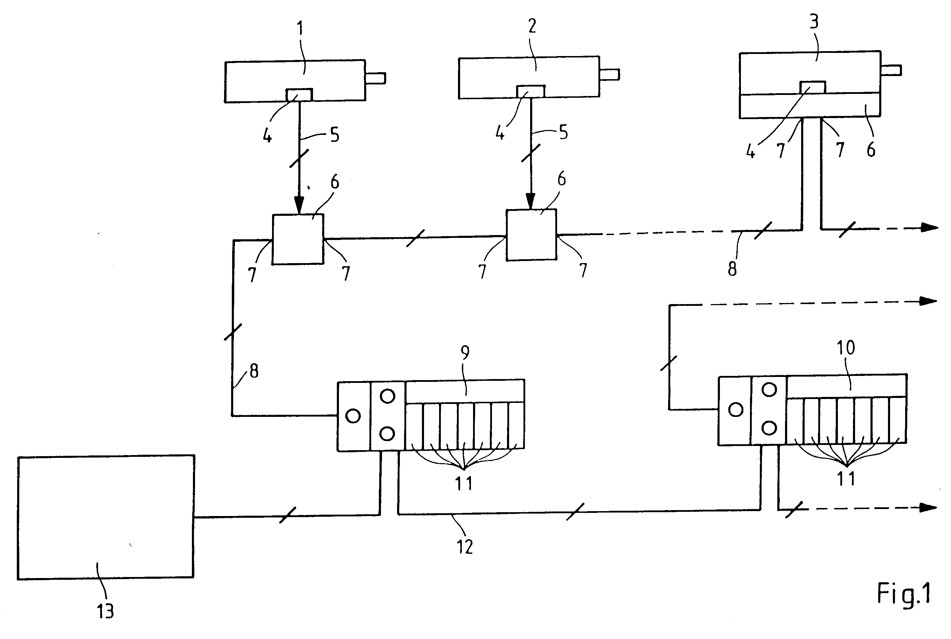

Ein Ausführungsbeispiel der erfindungsgemäßen Einrichtung wird anhand der Zeichnung erläutert. Die Figur zeigt ein Blockschaltbild der Komponenten einer Maschinensteuerung mit zwei Bussystemen.

### Beschreibung des Ausführungsbeispiels

In der Figur ist eine Einrichtung zur Steuerung einer Maschine dargestellt, bei der Stellglieder 1, 2 und 3 bestimmte Maschinenfunktionen steuern und/oder regeln können. Die Art der zu beeinflussenden Funktionen hängen vom Typ der hier nicht dargestellten Maschine ab und bestimmen daher auch die spezielle Ausbildung der Stellglieder 1 bis 3. Beispielsweise können dies pneumatisch ansteuerbare Schaltzylinder sein, die entweder mechanische, beziehungsweise elektrische Schalt- und/oder Regelfunktionen ausführen. An den Stellgliedern 1 bis 3 sind elektronische Sensoren oder Detektoren 4 angebracht, die den jeweiligen Schalt- oder Regelzustand erfassen und über eine Signalleitung 5 an Buskoppelbausteine 6 weiterleiten. Diese Signalleitung kann im einfachsten Fall aus zwei Leitern zur Signalübertragung plus eine zusätzliche Erdleitung bestehen.

Der gesamte Aufbau der Stellglieder 1 bis 3, der Detektoren oder Sensoren 4 sowie der Buskoppelbausteine 6 kann hierbei auf engstem Raum benachbart zueinander ausgeführt werden. Beim Stellglied 3 ist bereits der Buskoppelbaustein 6 direkt in das Gehäuse des Stellglieds integriert.

Die Buskoppelbausteine 6 weisen busseitige Anschlüsse 7 auf an denen ein zweites Bussystem 8 anschließbar ist. Dieses zweite Bussystem 8 enthält mindestens zwei Leiter zur Signalübertragung sowie eine Spannungsversorgung für die Stellglieder 1 bis 3, einschließlich der Buskoppelbausteine 6, und eine Erdleitung, so daß ein Fünfleitersystem, bzw. bei einem Verzicht auf die Erdleitung ein Vierleitersystem, hier ausreichend ist. Die in den Stellgliedern 1 bis 3 erfaßten Signale werden hierbei in den Buskoppelbausteinen 6 so aufbereitet, daß eine serielle Signalübertragung erfolgt.

Das zweite Bussystem 8 wird an Verteileranordnungen 9 und 10 angeschlossen, die eine Anzahl von pneumatisch betriebenen Schaltern 11 enthalten. Mit diesen Schaltern 11 werden über hier nicht dargestellte pneumatische Verbindungsleitungen die eigentlichen Steuer- und Regelfunktionen in den Stellgliedern 1 bis 3 bewerkstelligt.

Die Steuerung der Schalter 11 auf den pneumatischen Verteileranordnungen 9 und 10 erfolgt über ein erstes Bussystem 12, das von einer zentralen Steuereinheit 13 mit den entsprechenden Steuerdaten versorgt wird. Dieses zentrale erste Bussystem 12 kann beispielsweise ein standardisiertes Übertragungsprotokoll, wie zum Beispiel einen Feldbus, aufweisen, an den eine große Zahl von Verteileranordnungen oder auch Stellglieder direkt anschließbar ist.

## Patentansprüche

1. Einrichtung zur Steuerung von mechanischen oder elektromechanischen Stellgliedern, insbesondere pneumatischen Bauelementen, bei der
- die Stellglieder (1,2,3) über eine Verteileranordnung (9,10) betätigt werden und die Verteileranordnung (9,10) über ein elektronisches Bussystem (12) mit einer speicherprogrammierbaren, zentralen Steuereinheit (13) verbunden ist und
- eine Zustandsüberwachung der Stellglieder (1,2,3) über eine zumindest teilweise separate Signalverbindung (5) zwischen Sensoren/Detektoren (4) an den Stellgliedern (1,2,3) und der Verteileranordnung (9,10) und/oder der Steuereinheit (13) erfolgt,
**dadurch gekennzeichnet, daß**
- die Signalleitungen (5) der Sensoren/Detektoren (4) an den Stellgliedern (1,2,3) mit Buskoppelbausteinen (6) verbunden sind, die an einem zweiten elektronischen Bussystem (8) angeschlossen sind und daß
- das zweite elektronische Bussystem (8) an die Verteileranordnung (9,10) und die Steuereinheit (13) angeschlossen ist.

2. Einrichtung nach Anspruch 1 mit einer Anzahl pneumatischer Ventile auf der Verteileranordnung, die zur Steuerung von pneumatischen Zylindern als Stellglieder dienen,
**dadurch gekennzeichnet, daß**
- die Verteileranordnung (9,10) einen ersten Buskoppelbaustein mit mindestens einem Anschluß für das erste Bussystem (8), einen zweiten Buskoppelbaustein mit mindestens einem Anschluß für das zweite Bussystem (8) und eine Schaltungsanordnung zur Auswertung der Signale des zweiten Bussystems (8) und/oder zur Weiterleitung der Signale des zweiten Bussystems (8) an das erste Bussystem (12).

3. Einrichtung nach einem der Ansprüche 1 oder 2,
**dadurch gekennzeichnet, daß**
- das zweite Bussystem (8) aus fünf parallelen Leitungen einschließlich der Spannungsversorgungsleitungen für die Sensoren/Detektoren (4) besteht.

4. Einrichtung nach einem der Ansprüche 1 oder 2,
**dadurch gekennzeichnet, daß**
- das zweite Bussystem (8) aus vier parallelen Leitungen einschließlich der Spannungsversorgungsleitungen für die Sensoren/Detektoren (4) besteht.

5. Einrichtung nach einem der Ansprüche 1 bis 4,
**dadurch gekennzeichnet, daß**
- die Buskoppelbausteine (6) der Stellglieder (1,2,3) und die Sensoren/Detektoren (4) in den mechanischen Aufbau der Stellglieder (1,2,3) integriert sind.
